# EUROPÄISCHE PATENTANMELDUNG

(11) **EP 4 718 655 A1**
(43) Veröffentlichungstag der Anmeldung: **01.04.2026**
(21) Anmeldenummer: 24202465.1
(22) Anmeldetag: 25.09.2024
(51) Int. Cl.: H02H 7/26, H02H 3/04, G01R 31/327

(54) **ENDFEHLERSCHUTZVERFAHREN UND EINRICHTUNGEN FÜR ENDFEHLERSCHUTZVERFAHREN**

(71) Anmelder: Siemens Aktiengesellschaft, 80333 München (DE)
(72) Erfinder: Henn, Volker, 91056 Erlangen (DE); Romeis, Christian, 91052 Erlangen (DE)
(74) Vertreter: Siemens Patent Attorneys

(57) **Zusammenfassung**

Die Erfindung bezieht sich auf unter anderem auf ein Endfehlerschutzverfahren zum Überwachen eines Endabschnitts (11) einer elektrischen Anordnung (12). Erfindungsgemäß ist vorgesehen, dass dem Endabschnitt (11) ein ein Messsignal (Im) erzeugender Stromwandler (SW) und ein Endschalter (ES), der an eine dem Endschalter (ES) zugewandte erste Anschlussseite (A1) des Stromwandlers (SW) angeschlossen ist, zugeordnet ist, der zeitliche Verlauf des Messsignals (Im) beobachtet wird und ein Alarmsignal (AS) erzeugt wird, wenn das Messsignal (Im) nach einem Öffnen des Endschalters (ES) nicht oder nicht in einem erwarteten Maße auf Null abfällt.

## Beschreibung

Die Erfindung bezieht sich auf ein Schutzverfahren, nachfolgend Endfehlerschutzverfahren genannt, zum Überwachen eines Endabschnitts einer elektrischen Anordnung.

Der Erfindung liegt die Aufgabe zugrunde, ein Endfehlerschutzverfahren anzugeben, bei dem im Falle eines Fehlers im Bereich des Endabschnitts ein besonders schnelles Abschalten vom Fehler betroffener Abschnitte erreichbar ist.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass dem Endabschnitt ein ein Messsignal erzeugender Stromwandler und ein Endschalter, der an eine dem Endschalter zugewandte erste Anschlussseite des Stromwandlers angeschlossen ist, zugeordnet ist, der zeitliche Verlauf des Messsignals beobachtet wird und ein Alarmsignal erzeugt wird, wenn das Messsignal nach einem Öffnen des Endschalters nicht oder nicht in einem erwarteten Maße auf Null abfällt.

Ein wesentlicher Vorteil des erfindungsgemäßen Endfehlerschutzverfahrens besteht darin, dass die Information über das Vorliegen eines Fehlers, der zwischen dem Endschalter und dem Stromwandler liegt, bereits während des Öffnungsvorgangs des Endschalters bzw. unmittelbar danach ermittelt wird, wenn ein solcher Fehler bereits vor dem Beginn des Öffnungsvorgangs vorlag oder während des Öffnens auftritt. Aufgrund der Beobachtung des Messsignals während und nach dem Öffnungsvorgang kann somit besonders schnell ein vorhandener Fehler erkannt werden, und es können besonders schnell geeignete Schutzmaßnahmen ausgelöst werden.

Vorteilhaft ist es, wenn die Schalterstellung des Endschalters und damit der Öffnungsvorgang beim Öffnen des Endschalters mit einem Hilfskontakt überwacht wird und alle diejenigen Strommesswerte des Messignals, die vor dem von dem Hilfskontakt gemeldeten Abschluss des Öffnungsvorgangs erfasst worden sind, bei der Entscheidung über das Erzeugen des Alarmsignals unberücksichtigt bleiben.

Der letztgenannte Einsatz eines Hilfskontakts ist insbesondere dann von Vorteil, wenn es sich bei dem Endschalter um einen Leistungsschalter handelt, der bei Öffnungsvorgängen in der Regel sehr hohe Ströme schaltet. In einem solchen Falle werden nämlich während des Öffnungsvorgangs häufig noch Restströme beispielsweise durch Lichtbögen oder sonstige Entladungsvorgänge auftreten, die eine Auswertung des zeitlichen Verlaufs des Messignals mit Blick auf eine Fehlererkennung erschweren können. Aus diesem Grunde ist ein Unberücksichtigtlassen von Strommesswerten, die während des Öffnungsvorgangs erfasst werden, und eine Erkennung des vollständigen Abschlusses des Öffnungsvorgangs mittels eines Hilfskontakts sehr von Vorteil.

Mit Blick auf ein schnelles Isolieren der Fehlerstelle wird es als vorteilhaft angesehen, wenn bereits bei Vorliegen des Alarmsignals ein Abschaltsignal bzw. Steuerbefehl zum Öffnen zumindest eines weiteren Schalters erzeugt wird, der an eine zweite, dem Endschalter abgewandte Anschlussseite des Stromwandlers angeschlossen ist.

Der Endschalter und der Stromwandler sind bevorzugt unmittelbar miteinander verbunden; alternativ können noch weitere Komponenten elektrisch dazwischengeschaltet sein.

Bei der Anordnung, deren Endabschnitt überwacht wird, kann es sich beispielsweise um eine Sammelschiene eines Energieversorgungs- oder Energieverteilnetzes, einen Generator, eine elektrische Maschine, einen sonstigen elektrischen Verbraucher oder dergleichen handeln.

Vorteilhaft ist es, wenn der Endschalter ein Abzweigschalter eines Abzweigs einer Sammelschiene ist und der Stromwandler ein Abzweigstromwandler einer die Sammelschiene überwachenden Sammelschienendifferentialschutzeinrichtung ist.

Bei einer bevorzugten Ausführungsvariante ist vorgesehen, dass der Endschalter zwischen die Sammelschiene und den Abzweigstromwandler geschaltet ist und bei Vorliegen des Alarmsignals ein von der Sammelschiene unabhängiger und außerhalb des Schutzbereichs der Sammelschienendifferentialschutzeinrichtung liegender Schalter abgeschaltet wird.

Der außerhalb des Schutzbereichs der Sammelschienendifferentialschutzeinrichtung liegende Schalter, der abgeschaltet wird, liegt vorzugsweise elektrisch mit dem Abzweigstromwandler in Reihe.

Bei einer anderen bevorzugten Ausführungsvariante ist vorgesehen, dass der Abzweigstromwandler zwischen die Sammelschiene und den Endschalter geschaltet ist.

Im letztgenannten Falle kann in vorteilhafter Weise vorgesehen sein, dass bei Vorliegen des Alarmsignals ein Steuerbefehl an die Sammelschienendifferentialschutzeinrichtung übermittelt wird und die Sammelschienendifferentialschutzeinrichtung in Reaktion auf den Steuerbefehl alle ihr zugeordneten Abzweige durch Abschalten der zugehörigen Abzweigschalter ausschaltet.

Alternativ oder zusätzlich kann vorgesehen sein, dass bei Vorliegen des Alarmsignals die Sammelschiene von einem daran angeschlossenen Energieverteilnetz abgetrennt wird, indem unter Umgehung der Sammelschienendifferentialschutzeinrichtung alle der Sammelschienendifferentialschutzeinrichtung zugeordneten Abzweige durch Abschalten der zugehörigen Abzweigschalter unmittelbar geöffnet werden.

Das Abtrennen der Sammelschiene von dem daran angeschlossenen Energieverteilnetz erfolgt vorzugsweise, indem direkt mit dem Alarmsignal, also vorzugsweise ohne weitere Signalverarbeitung oder Signalumwandlung, als Steuerbefehl alle der Sammelschienendifferentialschutzeinrichtung zugeordneten Abzweigschalter unmittelbar geöffnet werden.

Der Endschalter kann ein Kuppelschalter sein, der eine erste Sammelschiene mit einer anderen Einrichtung, insbesondere einer zweiten Sammelschiene, verbindet.

Bei der letztgenannten Ausgestaltung ist es von Vorteil, wenn der Kuppelschalter außerdem ein Abzweigschalter eines Abzweigs der ersten Sammelschiene ist und der Stromwandler ein Abzweigstromwandler einer die erste Sammelschiene überwachenden Sammelschienendifferentialschutzeinrichtung ist.

Die Erfindung bezieht sich außerdem auf eine Endfehlerschutzeinrichtung zum Überwachen eines Endabschnitts einer elektrischen Anordnung, insbesondere zum Durchführen eines Endfehlerschutzverfahrens wie oben beschrieben. Erfindungsgemäß ist eine Auswerteinrichtung der Endfehlerschutzeinrichtung dazu ausgestaltet, den zeitlichen Verlauf eines Messsignals, das einen durch den Endabschnitt fließenden Strom angibt, zu beobachten und ein Alarmsignal zu erzeugen, wenn das Messsignal nach einem Öffnen eines dem Endabschnitt zugeordneten Endschalters nicht oder nicht in einem erwarteten Maße auf Null abfällt.

Bezüglich der Vorteile der erfindungsgemäßen Endfehlerschutzeinrichtung und deren vorteilhafter Ausgestaltungen sei auf die obigen Ausführungen im Zusammenhang mit dem erfindungsgemäßen Endfehlerschutzverfahren und dessen vorteilhafter Ausgestaltungen verwiesen.

Die Erfindung bezieht sich außerdem auf ein Computerprogrammprodukt. Erfindungsgemäß umfasst dieses Programmbefehle, die eine Datenverarbeitungsanlage veranlassen, die Auswerteinrichtung der beschriebenen Endfehlerschutzeinrichtung zu bilden und/oder ein Endfehlerschutzverfahren wie oben beschrieben durchzuführen.

Die Erfindung bezieht sich außerdem auf eine Datenverarbeitungsanlage. Erfindungsgemäß ist diese mit einem Computerprogrammprodukt wie oben beschrieben programmiert oder es ist zumindest ein solches Computerprogrammprodukt in einem Speicher der Datenverarbeitungsanlage abgespeichert.

Die Erfindung wird nachfolgend anhand von Ausführungsbeispielen näher erläutert; dabei zeigen beispielhaft:
- Fig. 1: ein erstes Ausführungsbeispiel für eine erfindungsgemäße Endfehlerschutzeinrichtung zum Überwachen eines Endabschnitts einer elektrischen Anordnung, wobei anhand der Figur 1 ein erstes Ausführungsbeispiel für ein erfindungsgemäßes Endfehlerschutzverfahren erläutert wird,
- Fig. 2: ein zweites Ausführungsbeispiel für eine erfindungsgemäße Endfehlerschutzeinrichtung zum Überwachen eines Endabschnitts einer Anordnung, wobei anhand der Figur 2 ein zweites Ausführungsbeispiel für ein erfindungsgemäßes Endfehlerschutzverfahren erläutert wird,
- Fig. 3: ein Ausführungsbeispiel für eine Sammelschienenanordnung, bei der ein Abzweig einer Sammelschiene mit einem Ausführungsbeispiel für eine erfindungsgemäße Endfehlerschutzeinrichtung ausgestattet ist, wobei dieser Abzweig mit dem im Zusammenhang mit der Figur 1 beschriebenen Endfehlerschutzverfahren überwacht wird,
- Fig. 4: ein Ausführungsbeispiel für eine Sammelschienenanordnung, bei der ein Abzweig einer Sammelschiene mit einem Ausführungsbeispiel für eine erfindungsgemäße Endfehlerschutzeinrichtung ausgestattet ist, wobei dieser Abzweig mit dem im Zusammenhang mit der Figur 2 beschriebenen Endfehlerschutzverfahren überwacht wird, und
- Fig.5: eine Ausführungsvariante des Ausführungsbeispiels gemäß Figur 4.

In den Figuren werden der Übersicht halber für identische oder vergleichbare Komponenten stets dieselben Bezugszeichen verwendet.

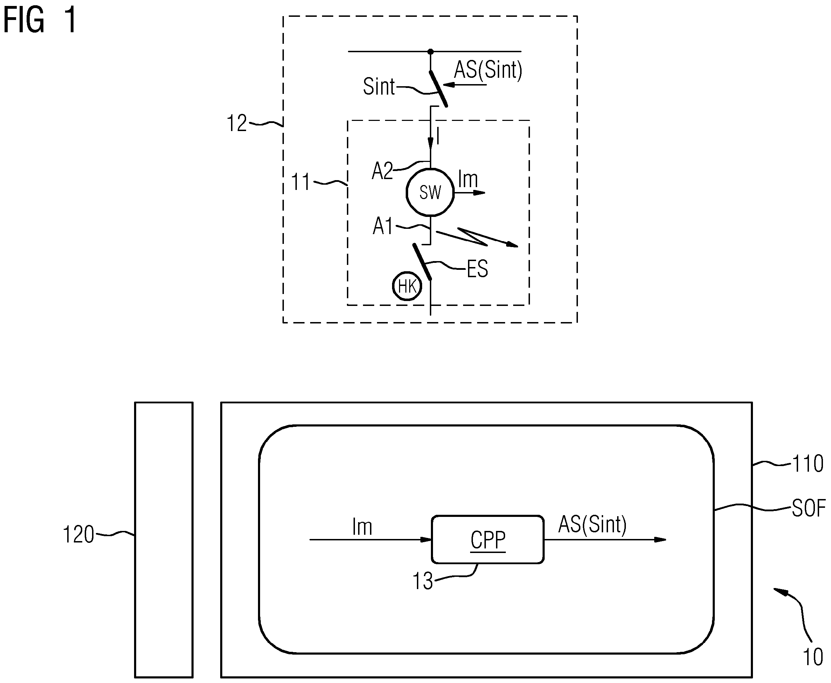

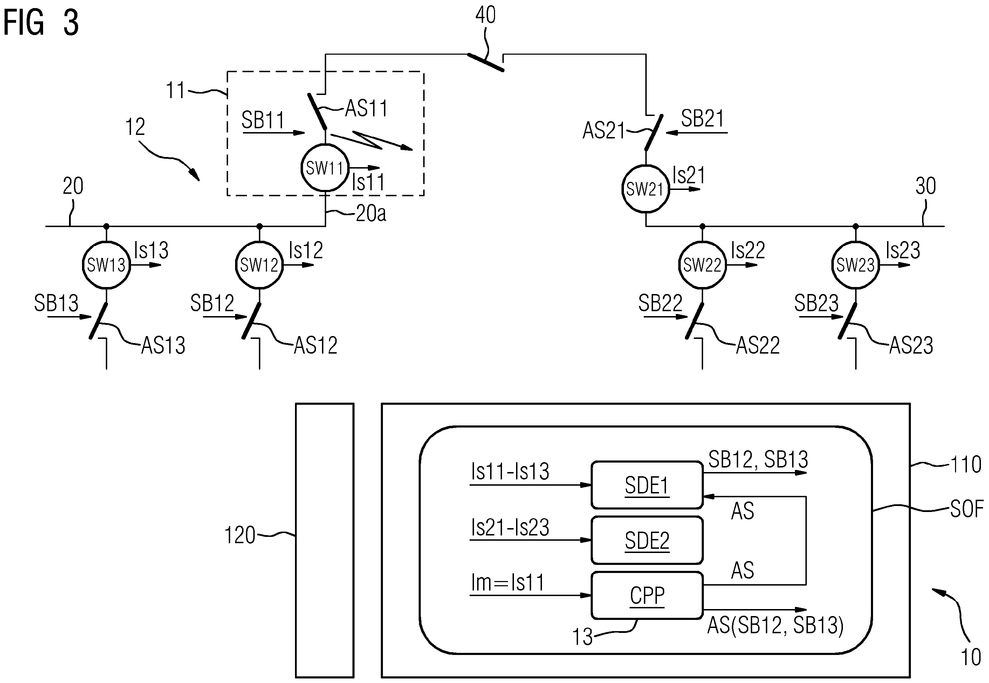

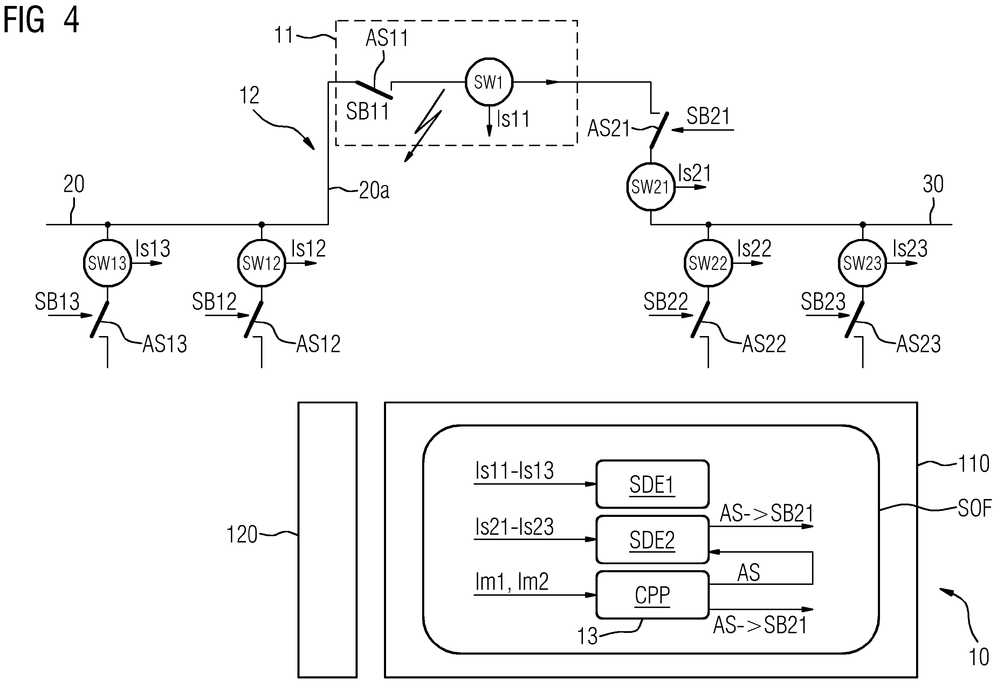

Die Figur 1 zeigt ein Ausführungsbeispiel für eine erfindungsgemäße Endfehlerschutzeinrichtung 10 zum Überwachen eines Endabschnitts 11 einer elektrischen Anordnung 12, die aus Gründen der Übersicht in der Figur 1 nicht näher dargestellt ist und bei der es sich beispielsweise um eine Sammelschiene (wie zum Beispiel die Sammelschiene 20 gemäß den Figuren 3 und 4) eines Energieversorgungs- oder Energieverteilnetzes, eine elektrische Maschine, einen Generator oder dergleichen handeln kann.

Der Endabschnitt 11 ist mit einem Stromwandler SW ausgestattet, der einen durch den Endabschnitt 11 fließenden Strom I unter Bildung eines Messsignals Im misst.

Außerdem umfasst der Endabschnitt 11 einen Endschalter ES, der an eine dem Endschalter ES zugeordnete erste Anschlussseite A1 des Stromwandlers SW angeschlossen ist. Der Endschalter ES und der Stromwandler SW liegen elektrisch in Reihe. Der Endschalter ES und der Stromwandler SW können unmittelbar, was bevorzugt wird, miteinander verbunden sein; alternativ können noch weitere Komponenten elektrisch dazwischengeschaltet sein.

Der Endschalter ES liegt bei der Figur 1 bezogen auf die Anordnung 12 und den Stromwandler SW außen, sodass der Stromwandler SW von der Anordnung 12 gesehen aus ein innenliegender Stromwandler ist und mit dem Strom I aus der Anordnung 12 gespeist werden kann, auch wenn der Endschalter ES geöffnet ist.

Eine Auswerteinrichtung 13 der Endfehlerschutzeinrichtung 10 dient dazu, den zeitlichen Verlauf des Messsignals Im des Stromwandlers SW unmittelbar nach einem Öffnen des Endschalters ES zu beobachten und ein Alarmsignal AS zu erzeugen, wenn das Messsignal Im nach dem Öffnen nicht oder nicht in einem erwarteten bzw. vorgegebenen Maße auf Null abfällt. In einem fehlerfreien Fall ist nämlich zu erwarten, dass der Strom I durch den Stromwandler SW abfällt, sobald der Endschalter ES geöffnet wird. Liegt hingegen zwischen dem Stromwandler SW und dem Endschalter ES ein Fehler, zum Beispiel ein Kurzschluss vor, wie in der Figur 1 durch einen Pfeil angedeutet ist, so kann der Strom I weiter über den Stromwandler SW zu der Fehlerstelle abfließen, sodass der Stromfluss trotz geöffnetem Endschalter ES anhält.

Bei Vorliegen des Alarmsignals AS gibt die Auswerteinrichtung 13 dieses vorzugsweise direkt als Abschaltsignal aus, vorzugsweise zum Öffnen zumindest eines weiteren Schalters, der an eine zweite, dem Endschalter ES abgewandte Anschlussseite A2 des Stromwandlers SW angeschlossen ist. Bei der Anordnung gemäß Figur 1 ist der weitere Schalter ein bezogen auf die Anordnung 12 interner Schalter Sint der Anordnung 12, der mit dem innenliegenden Stromwandler SW elektrisch verbunden ist, sei es mit diesem in Reihe liegt oder mit diesem nur mittelbar vernetzt ist. Vorzugsweise werden durch das Alarmsignal AS alle Zweige der Anordnung 12 abgeschaltet, die die Fehlerstelle speisen können.

Um zu vermeiden, dass bei der Auswertung des Messsignals Im Strommesswerte berücksichtigt werden, die vor oder während des Öffnungsvorgangs des Endschalter ES erfasst worden sind und die Auswertung des Messsignals Im erschweren oder verzögern könnten, überwacht die Auswerteinrichtung 13 die Schalterstellung des Endschalters ES und damit den Öffnungsvorgang beim Öffnen des Endschalters ES mit einem Hilfskontakt HK. Die Auswerteinrichtung 13 lässt vorzugsweise alle diejenigen Strommesswerte des Messignals Im, die vor dem von dem Hilfskontakt HK gemeldeten vollständigen Abschluss des Öffnungsvorgangs erfasst worden sind, bei der Entscheidung über das Erzeugen des Alarmsignals AS unberücksichtigt. Bei dem Endschalter ES handelt es sich vorzugsweise um einen Leistungsschalter.

Die Auswerteinrichtung 13 wird bei dem Ausführungsbeispiel gemäß Figur 1 durch ein Computerprogrammprodukt CPP gebildet, das in einem Speicher 110 einer Datenverarbeitungsanlage 100 der Endfehlerschutzeinrichtung 10 als Software SOF abgespeichert ist und von einer Recheneinrichtung 120 der Datenverarbeitungsanlage 100 ausgeführt wird.

Handelt es sich bei dem Messsignal Im, das von dem Stromwandler SW geliefert wird, um ein analoges Signal, so wird dieses vorzugsweise vor der Verarbeitung in der Datenverarbeitungsanlage 100, beispielsweise von der Recheneinrichtung 120 der Datenverarbeitungsanlage 100, zunächst analog-digital gewandelt, um eine computergestützte Verarbeitung zu vereinfachen.

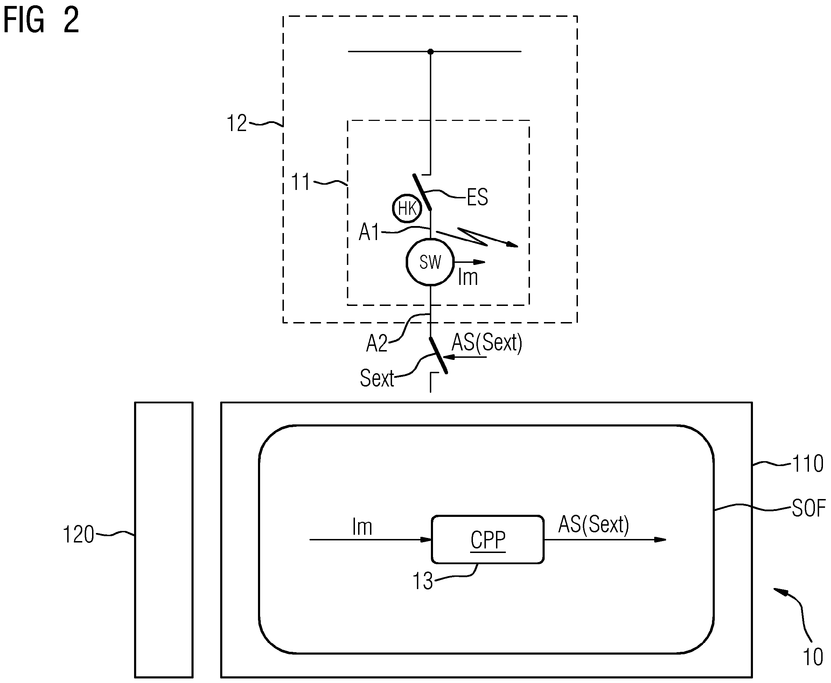

Die Figur 2 zeigt ein zweites Ausführungsbeispiel für eine erfindungsgemäße Endfehlerschutzeinrichtung 10 zum Überwachen eines Endabschnitts 11 einer elektrischen Anordnung 12.

Bei dem Endabschnitt 11 gemäß Figur 2 liegt der Endschalter ES bezogen auf die Anordnung 12 und den Stromwandler SW innen, sodass der Stromwandler SW von der Anordnung 12 gesehen aus außen liegt und von der Anordnung 12 aus nicht mit Strom I gespeist werden kann, wenn der Endschalter ES geöffnet ist.

In einem fehlerfreien Fall wird der Strom I durch den Stromwandler SW auf Null abfallen, sobald der Endschalter ES geöffnet wird. Liegt hingegen zwischen dem Stromwandler SW und dem Endschalter ES ein Fehler vor, zum Beispiel ein Kurzschluss, wie in der Figur 2 durch einen Pfeil angedeutet ist, so kann zwar kein Strom I von der Anordnung 12 aus in den Stromwandler SW eingespeist werden, jedoch ist eine Einspeisung von außen möglich.

Bei Vorliegen des Alarmsignals AS gibt die Auswerteinrichtung 13 dieses daher vorzugsweise direkt als Abschaltsignal zum Öffnen zumindest eines weiteren Schalters aus, der bezogen auf die Anordnung 12 ein externer Schalter Sext ist, also nicht zur Anordnung 12 gehört, und mit dem außenliegenden Stromwandler SW elektrisch verbunden ist, sei es mit diesem in Reihe liegt oder mit diesem nur mittelbar vernetzt ist. Vorzugsweise werden durch das Alarmsignal AS alle externen Schalter abgeschaltet, die die Fehlerstelle speisen können.

Im Übrigen gelten die obigen Ausführungen im Zusammenhang mit der Figur 1 für das Ausführungsbeispiel gemäß Figur 2 entsprechend.

Die Figur 3 zeigt eine Sammelschienenanordnung, die eine erste Sammelschiene 20 und eine zweite Sammelschiene 30 umfasst. Die beiden Sammelschienen 20 und 30 können jeweils eine Vielzahl an Abzweigen aufweisen; nachfolgend wird beispielhaft davon ausgegangen, dass jede jeweils mit drei Abzweigen ausgestattet ist. Jeder der Abzweige ist jeweils mit einem Abzweigschalter AS11-AS13 bzw. AS21-AS23 und einem Abzweigstromwandler SW11-SW13 bzw. SW21-SW23 ausgestattet. Die beiden Sammelschienen 20 und 30 stehen über einen Kuppelschalter 40 miteinander in Verbindung, der in geschlossener Stellung die beiden Sammelschienen 20 und 30 elektrisch miteinander verbindet und in geöffneter Stellung voneinander trennt.

Die Abzweigstromwandler SW11-SW13 bzw. SW21-SW23 messen jeweils den durch den zugeordneten Abzweig fließenden Strom unter Erzeugung von strombezogenen Messsignalen, die in der Figur 3 mit den Bezugszeichen Is11-Is13 bzw. Is21-Is23 bezeichnet sind. Die strombezogenen Messsignale können analoge oder digitale Signale, insbesondere binäre Signale, sein. Die Abzweigschalter AS1 1-AS13 bzw. AS21-AS23 sind durch Steuerbefehle SB11-SB13 bzw. SB21-SB23 ein- bzw. ausschaltbar.

Der ersten Sammelschiene 20 ist eine erste Sammelschienendifferentialschutzeinrichtung SDE1 zugeordnet, die die Messsignale Is11 bis Is13 der Abzweigstromwandler SW11-SW13 auswertet, wie dies für Sammelschienendifferentialschutzeinrichtungen allgemein bekannt ist: Weicht die Stromsumme der Messsignale Is11 bis Is13 der ersten Sammelschiene 20 über ein vorgegebenes Maß von Null ab, so öffnet die erste Sammelschienendifferentialschutzeinrichtung SDE1 mittels der Steuerbefehle SB11-SB13 die zugeordneten Abzweigschalter AS11-AS13 und trennt die erste Sammelschiene 20 elektrisch ab.

Der zweiten Sammelschiene 30 ist eine zweite Sammelschienendifferentialschutzeinrichtung SDE2 zugeordnet, die die Messsignale Is21 bis Is23 der zweiten Sammelschiene 30 auswertet: Weicht die Stromsumme der Messsignale Is21 bis Is23 der zweiten Sammelschiene 30 über ein vorgegebenes Maß von Null ab, so öffnet die zweite Sammelschienendifferentialschutzeinrichtung SDE2 mittels der Steuerbefehle SB21-SB23 die zugeordneten Abzweigschalter AS21-AS23 und trennt die zweite Sammelschiene 30 elektrisch ab.

Bei der in der Figur 3 gezeigten Sammelschienenanordnung wird einer der Abzweige, der mit dem Bezugszeichen 20a gekennzeichnet ist und den Abzweigschalter AS11 und den Abzweigstromwandler SW11 umfasst, einem Endfehlerschutzverfahren unterworfen, wie dies oben im Zusammenhang mit der Figur 1 erläutert worden ist. Zu diesem Zweck wird dieser Abzweig 20a bzw. zumindest der den Abzweigschalter AS11 und den Abzweigstromwandler SW11 umfassende Teilabschnitt davon als Endabschnitt 11 einer durch die erste Sammelschiene 20 gebildeten Anordnung 12 für das Endfehlerschutzverfahren angesehen und mittels der in der Figur 1 gezeigten Endfehlerschutzeinrichtung 10 auf einen Endfehler hin überwacht, wie dies oben im Zusammenhang mit der Figur 1 erläutert worden ist:
Bei dem in der Figur 3 gezeigten Ausführungsbeispiel wird die Auswerteinrichtung 13 also den zeitlichen Verlauf des Messsignals Is11 des Stromwandlers SW11 unmittelbar nach einem Öffnen des als Endschalter angesehenen Abzweigschalters AS11 beobachten und ein Alarmsignal AS erzeugen, wenn das Messsignal Is11 nach dem Öffnen nicht oder nicht in einem erwarteten bzw. vorgegebenen Maße auf Null abfällt. In einem fehlerfreien Fall ist nämlich zu erwarten, dass der Strom durch den Stromwandler SW11 abfällt, sobald der Abzweigschalter AS11 geöffnet wird. Liegt hingegen zwischen dem Stromwandler SW11 und dem Abzweigschalter AS11 ein Fehler vor, zum Beispiel ein Kurzschluss, wie in der Figur 3 angedeutet ist, so kann der Strom - gespeist von der ersten Sammelschiene 20 - weiter über den Stromwandler SW11 zu der Fehlerstelle abfließen, sodass der Stromfluss trotz geöffnetem Abzweigschalter AS11 anhält.

Bei Vorliegen des Alarmsignals AS gibt die Auswerteinrichtung 13 dieses vorzugsweise direkt als Steuer- bzw. Abschaltsignal SB12 und SB13 zum Öffnen aller übrigen Abzweigschalter AS12 bis AS13 der ersten Sammelschiene 20 aus. Alternativ kann die Auswerteinrichtung 13 das Alarmsignal AS an die erste Sammelschienendifferentialschutzeinrichtung SDE1 weiterleiten, damit diese das Öffnen der übrigen Abzweigschalter AS12 bis AS13 veranlassen kann.

Die Auswerteinrichtung 13 der Endfehlerschutzeinrichtung wird - wie oben erläutert - vorzugsweise durch ein Computerprogrammprodukt CPP gebildet, das in einem Speicher 110 einer Datenverarbeitungsanlage 100 als Software SOF abgespeichert ist und von einer Recheneinrichtung 120 der Datenverarbeitungsanlage 100 ausgeführt wird. Auch die beiden Sammelschienendifferentialschutzeinrichtungen SDE1 und SDE2 können softwaremäßig realisiert sein und als Softwaremodule der Software SOF beispielsweise ebenfalls in dem Speicher 110 abgespeichert sein und von der Recheneinrichtung 120 ausgeführt werden. Die Datenverarbeitungsanlage 100 bildet somit nicht nur die Endfehlerschutzeinrichtung 10, sondern auch die genannten Sammelschienendifferentialschutzeinrichtungen SDE1 und SDE2.

Handelt es sich bei den strombezogenen Messsignalen Is11-Is13 bzw. Is21-Is23, die von den Abzweigstromwandlern SW11-SW13 bzw. SW21-SW23 geliefert werden, um analoge Signale, so werden diese vorzugsweise vor der Verarbeitung in der Datenverarbeitungsanlage 100, beispielsweise von der Recheneinrichtung 120 der Datenverarbeitungsanlage 100, zunächst analog-digital gewandelt, um eine computergestützte Verarbeitung zu vereinfachen.

Die Figur 4 zeigt eine weitere Sammelschienenanordnung. Im Unterschied zu dem Ausführungsbeispiel gemäß Figur 3 übt der Abzweigschalter AS11 des Abzweigs 20a der ersten Sammelschiene 20 selbst die Funktion des in der Figur 3 gezeigten Kuppelschalters 40 aus, der die beiden Sammelschienen 20 und 30 verbinden oder trennen kann.

Der Stromwandler SW11 liegt bezogen auf die erste Sammelschiene 20 und den Abzweigschalter AS11 außen, sodass der Abzweig 20a bzw. zumindest der den Abzweigschalter AS11 und den Abzweigstromwandler SW11 umfassende Teilabschnitt davon als Endabschnitt 11 einer durch die erste Sammelschiene 20 gebildeten Anordnung 12 einem Endfehlerschutzverfahren unterworfen werden kann, wie dies oben im Zusammenhang mit der Figur 2 erläutert worden ist:
Bei dem in der Figur 4 gezeigten Ausführungsbeispiel wird die Auswerteinrichtung 13 also den zeitlichen Verlauf des Messsignals Is11 des Stromwandlers SW11 unmittelbar nach einem Öffnen des als Endschalter angesehenen Abzweigschalters AS11 beobachten und ein Alarmsignal AS erzeugen, wenn das Messsignal Is11 nach dem Öffnen nicht oder nicht in einem erwarteten bzw. vorgegebenen Maße auf Null abfällt. In einem fehlerfreien Fall ist nämlich zu erwarten, dass der Strom durch den Stromwandler SW11 abfällt, sobald der Abzweigschalter AS11 geöffnet wird. Liegt hingegen zwischen dem Stromwandler SW11 und dem Abzweigschalter AS11 ein Fehler vor, zum Beispiel ein Kurzschluss, wie in der Figur 4 angedeutet ist, so kann der Strom - gespeist von der zweiten Sammelschiene 30 - weiter über den Stromwandler SW11 zu der Fehlerstelle abfließen, sodass der Stromfluss trotz geöffnetem Abzweigschalter AS11 anhält.

Bei Vorliegen des Alarmsignals AS gibt die Auswerteinrichtung 13 dieses vorzugsweise direkt als Steuer- bzw. Abschaltsignal SB21 zum Öffnen zumindest des elektrisch am dichtesten liegenden Abzweigschalters AS21, besonders bevorzugt als Steuer- bzw. Abschaltsignal SB21-SB23 zum Abschalten aller Abzweigschalter AS21 bis AS23 der zweiten Sammelschiene 30, aus. Alternativ kann die Auswerteinrichtung 13 das Alarmsignal AS an die zweite Sammelschienendifferentialschutzeinrichtung SDE2 weiterleiten, damit diese das Öffnen zumindest des elektrisch am dichtesten liegenden Abzweigschalters AS21, vorzugsweise aller Abzweigschalter AS21 bis AS23 der zweiten Sammelschiene 30, veranlassen kann.

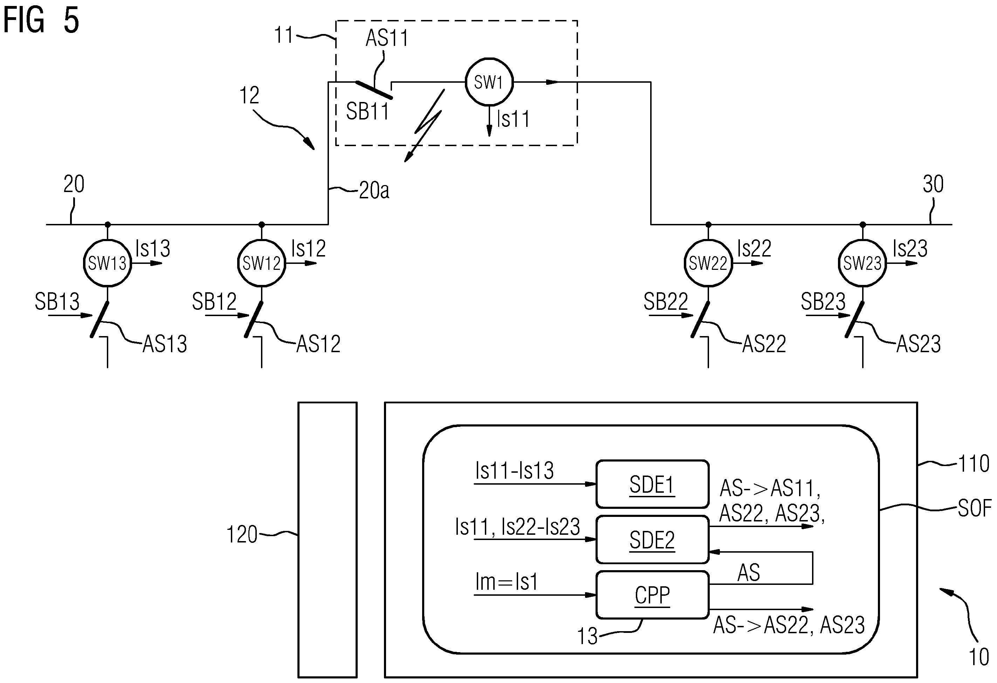

Die Figur 5 zeigt eine Ausführungsvariante des Ausführungsbeispiels gemäß Figur 4, bei der der Abzweigschalter AS21 und der Stromwandler SW21 bei der zweiten Sammelschiene 30 fehlen und die Sammelschienendifferentialschutzeinrichtung SDE2 ersatzweise den Abzweigschalter AS11 und den Stromwandler SW11 der ersten Sammelschiene 20 für den Sammelschienendifferentialschutz nutzt. Im Übrigen gelten die obigen Ausführungen im Zusammenhang mit der Figur 4 entsprechend.

Bei den in den Figuren 3, 4 und 5 gezeigten Sammelschienenanordnungen wurde beispielhaft davon ausgegangen, dass nur einer der Abzweige einem Endfehlerschutzverfahren unterworfen wird; selbstverständlich können auch mehr als ein Abzweig, beispielsweise alle Abzweige der ersten und/oder der zweiten Sammelschiene 20 und 30 jeweils mit einem Endfehlerschutzverfahren, wie oben im Zusammenhang mit den Figuren 1 und 2 beschrieben, überwacht werden.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

### Bezugszeichenliste

- 10: Endfehlerschutzeinrichtung
- 11: Endabschnitt
- 12: Anordnung
- 13: Auswerteinrichtung
- 20: erste Sammelschiene
- 20a: Abzweig
- 30: zweite Sammelschiene
- 40: Kuppelschalter
- 100: Datenverarbeitungsanlage
- 110: Speicher
- 120: Recheneinrichtung
- A1: erste Anschlussseite
- A2: zweite Anschlussseite
- AS: Alarmsignal
- AS11-AS13: Abzweigschalter
- AS21-AS23: Abzweigschalter
- CPP: Computerprogrammprodukt
- ES: Endschalter
- HK: Hilfskontakt
- I: Strom
- Im: Messsignal
- Is11-Is13: Messsignal
- Is21-Is23: Messsignal
- SB: Steuerbefehl
- SB11-SB13: Steuerbefehl
- SB21-SB23: Steuerbefehl
- SDE1: erste Sammelschienendifferentialschutzeinrichtung
- SDE2: zweite Sammelschienendifferentialschutzeinrichtung
- Sext: externer Schalter
- Sint: interner Schalter
- SOF: Software
- SW: Stromwandler
- SW11-SW13: Abzweigstromwandler
- SW21-SW23: Abzweigstromwandler

## Patentansprüche

1. Endfehlerschutzverfahren zum Überwachen eines Endabschnitts (11) einer elektrischen Anordnung (12),
**dadurch gekennzeichnet, dass**
- dem Endabschnitt (11) ein ein Messsignal (Im) erzeugender Stromwandler (SW) und ein Endschalter (ES), der an eine dem Endschalter (ES) zugewandte erste Anschlussseite (A1) des Stromwandlers (SW) angeschlossen ist, zugeordnet ist,
- der zeitliche Verlauf des Messsignals (Im) beobachtet wird und
- ein Alarmsignal (AS) erzeugt wird, wenn das Messsignal (Im) nach einem Öffnen des Endschalters (ES) nicht oder nicht in einem erwarteten Maße auf Null abfällt.

2. Endfehlerschutzverfahren nach Anspruch 1,
**dadurch gekennzeichnet, dass**
die Schalterstellung des Endschalters (ES) und damit der Öffnungsvorgang beim Öffnen des Endschalters (ES) mit einem Hilfskontakt (HK) überwacht wird und alle diejenigen Strommesswerte des Messignals, die vor dem von dem Hilfskontakt (HK) gemeldeten Abschluss des Öffnungsvorgangs erfasst worden sind, bei der Entscheidung über das Erzeugen des Alarmsignals (AS) unberücksichtigt bleiben.

3. Endfehlerschutzverfahren nach einem der voranstehenden Ansprüche,
**dadurch gekennzeichnet, dass**
bei Vorliegen des Alarmsignals (AS) ein Steuerbefehl zum Öffnen zumindest eines weiteren Schalters erzeugt wird, der an eine zweite, dem Endschalter (ES) abgewandte Anschlussseite (A2) des Stromwandlers (SW) angeschlossen ist.

4. Endfehlerschutzverfahren nach einem der voranstehenden Ansprüche,
**dadurch gekennzeichnet, dass**
- der Endschalter (ES) ein Abzweigschalter eines Abzweigs einer Sammelschiene (20) ist und
- der Stromwandler (SW) ein Abzweigstromwandler (SW11) einer die Sammelschiene (20) überwachenden Sammelschienendifferentialschutzeinrichtung (SDE1) ist.

5. Endfehlerschutzverfahren nach Anspruch 4,
**dadurch gekennzeichnet, dass**
der Endschalter (ES) zwischen die Sammelschiene (20) und den Abzweigstromwandler (SW11) geschaltet ist und bei Vorliegen des Alarmsignals (AS) ein von der Sammelschiene (20) unabhängiger und außerhalb des Schutzbereichs der Sammelschienendifferentialschutzeinrichtung (SDE1) liegender Schalter (AS21) abgeschaltet wird.

6. Endfehlerschutzverfahren nach Anspruch 5,
**dadurch gekennzeichnet, dass**
der außerhalb des Schutzbereichs der Sammelschienendifferentialschutzeinrichtung (SDE1) liegende Schalter, der abgeschaltet wird, elektrisch mit dem Abzweigstromwandler (SW11) in Reihe liegt.

7. Endfehlerschutzverfahren nach Anspruch 4,
**dadurch gekennzeichnet, dass**
der Abzweigstromwandler (SW11) zwischen die Sammelschiene (20) und den Endschalter (AS11) geschaltet ist.

8. Endfehlerschutzverfahren nach Anspruch 7,
**dadurch gekennzeichnet, dass**
das Alarmsignal (AS) an die Sammelschienendifferentialschutzeinrichtung (SDE1) übermittelt wird und die Sammelschienendifferentialschutzeinrichtung (SDE1) in Reaktion auf das Alarmsignal (AS) alle ihr zugeordneten Abzweige durch Öffnen der zugehörigen Abzweigschalter ausschaltet.

9. Endfehlerschutzverfahren nach Anspruch 7,
**dadurch gekennzeichnet, dass**
bei Vorliegen des Alarmsignals (AS) die Sammelschiene (20) von einem daran angeschlossenen Energieverteilnetz abgetrennt wird, indem unter Umgehung der Sammelschienendifferentialschutzeinrichtung (SDE1) alle der Sammelschienendifferentialschutzeinrichtung (SDE1) zugeordneten Abzweige durch Öffnen der zugehörigen Abzweigschalter (AS12, AS13) unmittelbar abgeschaltet werden.

10. Endfehlerschutzverfahren nach Anspruch 9,
**dadurch gekennzeichnet, dass**
das Abtrennen der Sammelschiene (20) von einem daran angeschlossenen Energieverteilnetz direkt mit dem Alarmsignal (AS) erfolgt, das als Steuerbefehl (SB12, SB13) zum Abschalten der zugehörigen Abzweigschalter an diese übermittelt wird.

11. Endfehlerschutzverfahren nach einem der voranstehenden Ansprüche,
**dadurch gekennzeichnet, dass**
der Endschalter (ES) ein Kuppelschalter ist, der eine erste Sammelschiene (20) mit einer anderen Einrichtung, insbesondere einer zweiten Sammelschiene (30), verbindet.

12. Endfehlerschutzverfahren nach Anspruch 11,
**dadurch gekennzeichnet, dass**
- der Kuppelschalter außerdem ein Abzweigschalter (AS11) eines Abzweigs der ersten Sammelschiene (20) ist und
- der Stromwandler ein Abzweigstromwandler (SW11) einer die erste Sammelschiene (20) überwachenden Sammelschienendifferentialschutzeinrichtung (SDE1) ist.

13. Endfehlerschutzeinrichtung (10) zum Überwachen eines Endabschnitts (11) einer elektrischen Anordnung (12), insbesondere zum Durchführen eines Endfehlerschutzverfahrens nach einem der voranstehenden Ansprüche,
**dadurch gekennzeichnet, dass**
eine Auswerteinrichtung (13) der Endfehlerschutzeinrichtung (10) dazu ausgestaltet ist, den zeitlichen Verlauf eines Messsignals (Im), das einen durch den Endabschnitt (11) fließenden Strom angibt, zu beobachten und ein Alarmsignal (AS) zu erzeugen, wenn das Messsignal (Im) unmittelbar nach einem Öffnen eines dem Endabschnitt (11) zugeordneten Endschalters (ES) nicht oder nicht in einem erwarteten Maße auf Null abfällt.

14. Computerprogrammprodukt (CPP),
**dadurch gekennzeichnet, dass**
das Computerprogrammprodukt (CPP) Programmbefehle umfasst, die eine Datenverarbeitungsanlage (100) veranlassen, die Auswerteinrichtung (13) der Endfehlerschutzeinrichtung (10) gemäß Anspruch 13 zu bilden und/oder ein Endfehlerschutzverfahren nach einem der voranstehenden Ansprüche durchzuführen.

15. Datenverarbeitungsanlage (100),
**dadurch gekennzeichnet, dass**
die Datenverarbeitungsanlage (100) mit einem Computerprogrammprodukt (CPP) nach Anspruch 14 programmiert ist oder zumindest in einem Speicher (110) der Datenverarbeitungsanlage (100) abgespeichert ist.
